# EUROPEAN PATENT SPECIFICATION

(11) **EP 0 424 925 B1**
(45) Date of publication and mention of the grant of the patent: **13.12.1995**
(21) Application number: 90120432.1
(22) Date of filing: 24.10.1990
(51) Int. Cl.: H01L 21/265, H01J 37/317

(54) **Method of removing electric charge accumulated on a semiconductor substrate in ion implantation**
Methode zur Beseitigung von elektrischen Ladungen, welche sich auf dem Halbleitersubstrat während der Ionenimplantation aufbauen
Méthode pour supprimer l'accumulation de charges électriques sur un substrat semi-conducteur pendant l'implantation ionique

(30) Priority: 25.10.1989 JP 276012/89
(43) Date of publication of application: 02.05.1991
(73) Proprietor: KABUSHIKI KAISHA TOSHIBA, Kawasaki-shi, Kanagawa-ken 210 (JP)
(72) Inventor: Yoshida, Yukimasa, Yokohama-shi, Kanagawa-ken (JP); Okumura, Katsuya, Yokohama-shi, Kanagawa-ken (JP)
(74) Representative: Lehn, Werner, Dipl.-Ing.

(56) References cited:
- WO-A-91/13458
- US-A- 4 639 301
- PATENT ABSTRACTS OF JAPAN (E-852)(13534) 29 November 1989 & JP-A-1 220 350

## Description

The present invention relates to a method of removing electric charge accumulated on a semiconductor substrate in ion implantation, comprising the steps of implanting ions by irradiating an ion beam onto the semiconductor substrate so as to form an impurity layer therein; and irradiating a predetermined portion of the semiconductor substrate with electrons simultaneously with the ion beam. Such a method is discussed in JP-A-01-220 350.

The integration degree of integrated circuits has been increased about four times these three years. The improvement of the integration degree has been achieved by finely making structure of the semiconductor devices. In order to make the structure extremely fine, it is necessary and effective to reduce the thickness of insulating films of the devices. For example, in an usual MOS type device, a silicon oxide film (SiO₂) with a thickness of 10nm is generally used as the insulating film thereof. While, the insulating film is formed by the so-called ion implantation in which positive ions are accelerated toward the substrate of the device and implanted therein at a high speed. Positive electric charge therefore is accumulated on the substrate (Charge-up Phenomenon), so that the insulating film is likely to be destroyed when an excessive electric stress is given thereto. As the result, the reliability of semiconductor devices is degraded, and the productivity thereof is lowered.

To prevent the charge-up phenomenon, there is a known method in which an electron beam is irradiated to the substrate or ion beam by using an electron flat gun (EFG).

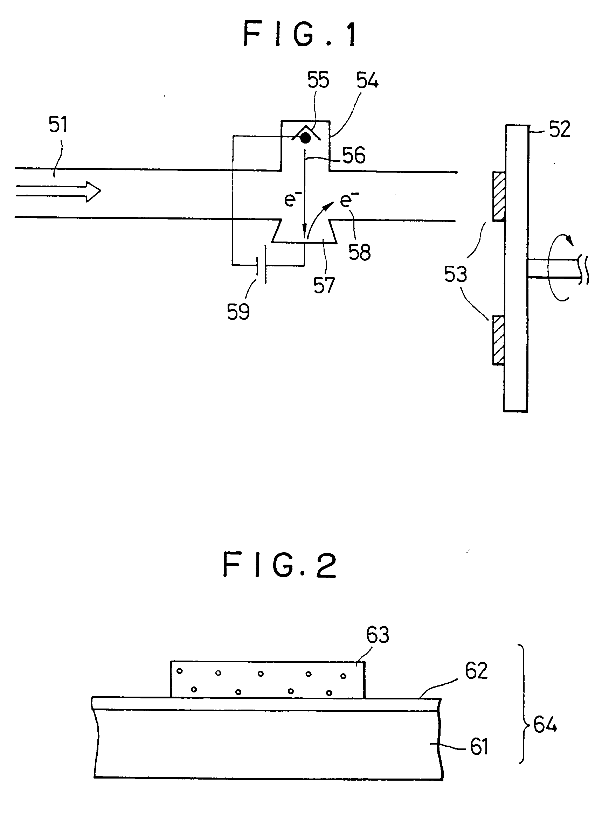

Fig.1 shows a cross section of a conventional ion implantation equipment. An ion beam S1 which emerges from an ion source (not shown) is accelerated, then implanted into a semiconductor substrate 53 mounted on a disc 52. In the same drawing, reference numeral 54 designates an electron flat gun (EFG) for preventing positive charge-up to be generated on the surface of the substrate 53 by the ion beam 51. In the electron flat gun 54, primary electrons generated from a tungsten (W) wire 55 are accelerated, then collide with a target 57, so that secondary electrons 58 are generated from the target 57. Thereafter, the secondary electrons 58 are introduced on the substrate 53, so that positive electric charge having been accumulated on the substrate 53 is neutralized. The amount of the secondary electron beam irradiated on the substrate 53 can be detected by monitoring the flow of the secondary electrons 58 to the disc 52, further controlled by changing values of voltage 59 applied for generating the secondary electrons 58.

However, since the degree of charge-up varies with conditions of the surface structure of the substrate 53, it is very difficult to adjust the irradiation amount of the electron beam 56 given from the EFG most suitably for satisfying all the surface conditions of the substrate 53. For example, when the amount of the irradiation of the electron beam 56 exceeds an amount just corresponding to the amount of charge-up, the surface of the substrate 53 is charged negatively. Moreover, in case of a CMOS type semiconductor device, the amount of the P channel portion thereof is different from that of the N channel portion. Therefore, it is impossible to prevent the charge-up phenomena to be generated on both of the channel sides simultaneously by the conventional method.

On the other hand, to prevent the charge-up phenomenon, it is also conceivable to reduce the amount of the ion beam without using the EFG, or to substantially reduce the amount per predetermined period by decreasing the duty ratio. However, when the dose of ion beam is relatively large, the throughput of the ion implantation is inevitably degraded. Accordingly, these methods are not so effective to solve the problem either.

Fig.2 shows a cross section of a semiconductor substrate 64 for detecting electric damage caused by the conventional ion implantation designated above.

In fabrication of the semiconductor substrate 64, first of all, an SiO₂ film 62 with a thickness of 20nm is formed on a P type silicon (Si) substrate 61, then a phosphorus-diffusion poly silicon film (Poly Si) 63 with a thickness of 400nm is formed on the SiO₂ film 62. Thereafter, the Poly Si 63 is processed by the CDE (Chemical Dry Etching) so as not to damage the substrate composition. Then, the processed material is annealed for about 60 minutes in a N₂ gas atmosphere at 900 °C so as to obtain the semiconductor substrate 64.

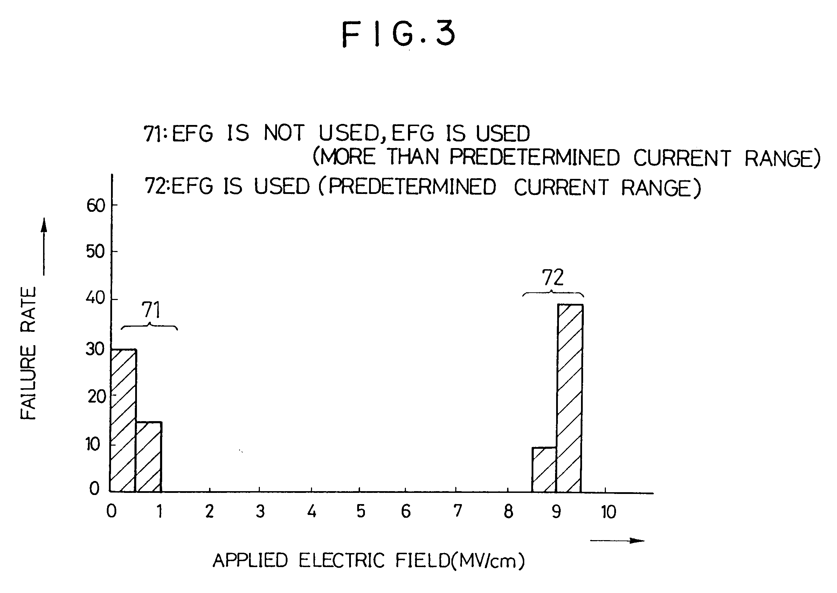

Fig.3 is a diagram to show the relation between a failure rate concerning insulating property and an applied electric field with respect to the substrate 64 subjected to a conventional high-dose ion implantation. In the diagram, the horizontal axis shows the electric field applied to the poly-Si 61 (where the Si substrate 61 is given the ground voltage), and the vertical axis shows the failure rate thereof.

As clearly seen from the same drawing, when the EFG is not used for the ion implantation, the insulating resistance of some resultant substrate 64 is destroyed under the condition of the electric field less than 1MV/cm. The failure rate thereof is shown by the shaded portion indicated with the reference numeral 71 in Fig. 3.

On the other hand, when the current of the EFG is used in the predetermined range for the ion implantation, the failure rate of the resultant insulating resistance is obtained as high as that of the normal SiO₂ film (see 8.5 to 9.5 MV/cm shown by the shaded portion in Fig. 3).

But, when the current of the EFG is in the range more than in the predetermined current range, the failure rate of the resultant insulating resistance of the substrate is in less than 1 MV/cm. Namely, the current of the EFG is so high that the amount of the electron generated by it is large.

The proper range of the current applied to the EFG is depended on the structure of the semiconductor substrate or the existence of the resist on the substrate can be determined.

When the current range applied to the EFG is narrow, the charge-up on the surface of the substrate is protected at one portion on the substrate, but is can not be guarded at other portion. Because the amount of the electron generated by the EFG is not full so as to neutralise the positive electric charge on the surface of the substrate or is not lacking in order to delete it. In these cases, the substrate is charged with the positive electric charge in the positive state or with the electron in the negative state.

An object of the invention is to provide a method of removing, or preventing generation of, electric charge applied to a semiconductor substrate in the ion implantation by suppressing generation of the charge-up phenomenon without the drop of the throughput of the process and damaging the substrate.

According to the invention, the method initially defined is characterised in that the electrons are accelerated in a beam with an acceleration voltage in the range from 1 to 50 KeV; and the electric charge is eliminated from the substrate by electrical current induced by the electron beam.

These and other objects, features and advantages of the present invention will be more apparent from the following description of a preferred embodiment, taken in conjunction with the accompanying drawings, in which:
Fig.1 is a cross section to show composition of a conventional ion implantation apparatus,
Fig.2 is a cross section of a semiconductor substrate to be used for an insulation test,
Fig. 3 is a diagram showing the failure rate of insulating property on conventional ion implantation,
Fig. 4 is a cross section to show the composition of an ion implantation apparatus which is an embodiment of the present invention,
Figs. 5 and 6 are cross sections of a wafer showing electron beam induced current (EBIC), and
Fig. 7 is a cross section to show composition of an ion implantation apparatus which is another embodiment of the present invention.

Hereinafter, the present invention will be described with reference to the drawings.

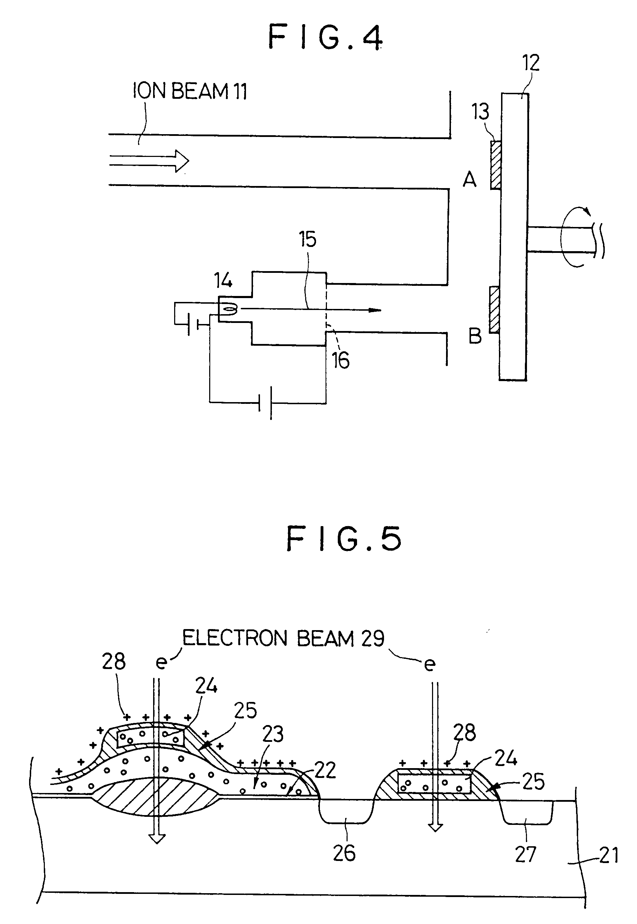

Fig.4 is a schematic cross section of an ion implantation apparatus which is an embodiment of the present invention.

In the same drawing, reference numeral 14 shows an electron generating source, and 16 designates a grid for accelerating the electrons and controlling energy of an electron beam 15.

Incidentally, the electron beam 15 is controlled by adjusting an amount of an electric current flowing in a W (tungsten) wire (not shown) in the electron generating source 14. While, reference numeral 11 denotes an ion beam, 12 is a rotatable disc, and 13 shows a semiconductor substrate. The ion implantation apparatus of this embodiment is so substantially composed of the above-mentioned parts that the accelerated electron beam 15 is introduced onto the substrate 13 on the disc 12 located at a position designated by B.

Next, operation of the ion implantation apparatus is explained.

The ion beam 11 generated from an ion source (not shown) is accelerated and introduced onto the substrate 13 located at a position designated by A. Since the disc 12 is rotated during the operation, the substrate 13 is irradiated with the ion beam 11 one after another at predetermined intervals. Then, the substrate 13 in which implanted ions from the ion beam 11 are moved to the position B successively by the rotation of the disc 12. Thereafter, the substrate 13 is irradiated with the highly accelerated electron beam 15. The current density of the electron beam 15 depends on the dose of ion implantation and the rotation speed of the disc 12, however, the value is so set as to be about 1/5 to 1/10 as compared with the current density based on the ions to be implanted in the substrate 13. Incidentally, in case of setting the energy for accelerating the electrons, though it is necessary to consider the surface structure of the substrate 13, generally, it can be suitably set in the range from about 1 to 50keV.

Fig.5 is a cross section schematically showing a charge-up phenomenon in the surface of a semiconductor substrate 21 in a typical DRAM structure. As shown in the same drawing, the DRAM structure includes a Si substrate 21, an insulating (SiO₂) film 22, a poly-silicon electrode 23 for accumulating electrons, another poly-silicon electrode 24 of a transistor for readout, and an LDD spacer 25 (as SiO₂ formed by CVD). Moreover, 26 and 27 show a source region and a drain region of the transistor, and each of these regions is formed by an ion implantation with a high dose.

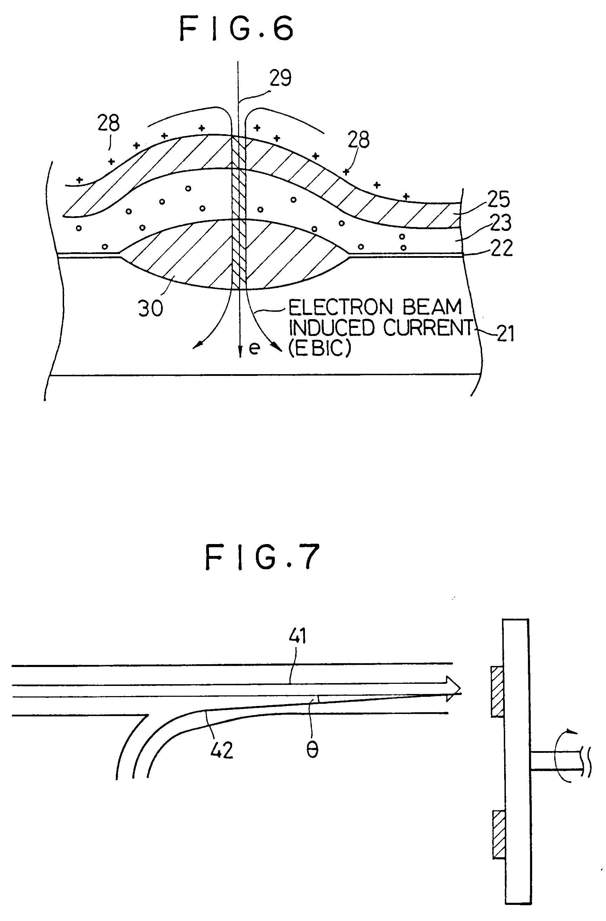

Fig.6 shows an enlarged view of the portion shown in Fig.5 and having been irradiated with the ion beam.

In such a case, a region (usually having a diameter from 30 to 50mm) irradiated with the ion beam is charged positively by positive electric charge 28 (designated by the character of "+"). Then, a highly accelerated electron beam 29 is irradiated onto the positively charged region. Thereby, the positive electric charges 28 are introduced toward the substrate 21 with an electron beam 29. As the result, the electron beam induced current (EBIC) is generated so as to remove the positive electric charges 28 in the surface of the semiconductor substrate 21.

In this embodiment, arsenic (As) ions, as the ion, are accelerated under acceleration voltage of 50keV so as to generate the ion beam. Moreover, the dose of the ion beam is set at 1 × 10¹⁶ cm⁻² and the beam diameter thereof is controlled to be 30mm under a current value of 5mA. On the other hand, the acceleration voltage of the electron beam 29 is set at 50keV under a current value of 50» A.

After the ion implantation is completed under the conditions mentioned above, the substrate is annealed for 30 minutes at 900°C in an N₂ atmosphere. Then, the resultant substrate is subjected to the insulation test with respect to the SiO₂ film 22. As the result, the initial failure mode (A mode) designated by 71 shown in Fig.3 can be eliminated.

Incidentally, Fig.4 shows a method of irradiating the substrate 13 with a highly accelerated electron beam 15 and a highly accelerated ion beam separately; On the other hand, as shown in Fig.7, it is also possible to irradiate these beams (the electron beam 15 and the ion beam 11) onto the substantially the same portions at the same time. Namely, as shown in Fig.7, an electron beam 42 may be joined with an ion beam 41 by bending the electron beam 42 by use of a required magnetic field (not shown).

Moreover, in both of the embodiments respectively shown in Figs. 4 and 7, the operations for irradiating the ion beam and electron beam are carried out independently of each other. However, it is possible to carry out both of the operations (irradiating the ion beam and the electron beam) in synchronism with each other.

As stated above, since the highly accelerated electron beam is irradiated onto the surface of the substrate on the ion implantation, an electric current is generated on the substrate by the electron beam, so that electron charge having been or to be accumulated on the surface of the substrate is cancelled or removed by the electric current.

Accordingly, the destruction of the insulating film in a semiconductor device caused by electric stress can be avoided, so that the throughput in production of the device can be improved, further high reliability required therefor can be guaranteed.

## Claims

1. A method of removing electric charge (28) accumulated on a semiconductor substrate (21) in ion implantation, comprising the steps of:
implanting ions by irradiating an ion beam (11) onto the semiconductor substrate (21) so as to form an impurity layer therein; and
irradiating a predetermined portion of the semiconductor substrate with electrons (15),
characterised in that:
the electrons are accelerated in a beam (15) with an acceleration voltage in the range from 1 to 50 KeV; and the electric charge (28) is eliminated from the substrate by electrical current induced by the electron beam (15).

2. A method according to claim 1, wherein
the accelerated electron beam (42) is combined with the ion beam (41), and irradiated onto a predetermined portion of the semiconductor substrate (21) together with the ion beam (41).

3. A method according to claim 1 wherein
the accelerated electron beam is irradiated onto a predetermined portion of the semiconductor substrate in synchronism with the ion beam.

4. A method according to claim 1 wherein
the accelerated electron beam is irradiated onto a predetermined portion of the semiconductor substrate at a different time than is the ion beam.

5. A method according to any preceding claim wherein the current density of the electron beam is set to be about 1/5 to 1/10 of the ion beam current density.

## Patentansprüche

1. Verfahren zum Entfernen einer elektrischen Ladung (28), die bei einer Ionenimplantation auf einem Halbleitersubstrat (21) angesammelt ist, umfassend die folgenden Schritte:
Implantieren von Ionen durch Aufstrahlen eines Ionenstrahls (11) auf das Halbleitersubstrat (21), um so eine Verunreinigungsschicht darin zu bilden; und
Bestrahlen eines vorgegebenen Abschnitts des Halbleitersubstrats mit Elektronen (15);
dadurch gekennzeichnet, daß:
die Elektronen in einem Strahl (15) mit einer Beschleunigungsspannung im Bereich von 1 bis 50 KeV erzeugt werden; und die elektrische Ladung (28) durch einen elektrischen Strom beseitigt wird, der durch den Elektronenstrahl (15) verursacht wird.

2. Verfahren nach Anspruch 1, dadurch gekennzeichnet, daß der beschleunigte Elektronenstrahl (42) mit dem Ionenstrahl (41) kombiniert und auf einen vorgegebenen Abschnitt des Halbleitersubstrats (21) zusammen mit dem Ionenstrahl (41) aufgestrahlt wird.

3. Verfahren nach Anspruch 1, dadurch gekennzeichnet, daß der beschleunigte Elektronenstrahl auf einen vorgegebenen Abschnitt des Halbleitersubstrats synchron mit dem Ionenstrahl aufgestrahlt wird.

4. Verfahren nach Anspruch 1, dadurch gekennzeichnet, daß der beschleunigte Elektronenstrahl auf einen vorgegebenen Abschnitt des Halbleitersubstrats zu einer anderen Zeit als der Ionenstrahl aufgestrahlt wird.

5. Verfahren nach einem der vorangehenden Ansprüche, dadurch gekennzeichnet, daß die Stromdichte des Elektronenstrahls auf ungefähr einen Faktor von 1/5 bis 1/10 der Ionenstrahlstromdichte eingestellt ist.

## Revendications

1. Procédé pour supprimer des charges électriques (28) accumulées sur un substrat semi-conducteur (21) pendant l'implantation ionique, comprenant les étapes consistant à :
implanter des ions en faisant rayonner un faisceau d'ions (11) sur le substrat semi-conducteur (21) de façon à former une couche d'impuretés dans celui-ci ; et
faire rayonner sur une partie prédéterminée du substrat semi-conducteur des électrons (15),
caractérisé en ce que :
les électrons sont accélérés en un faisceau (15) avec une tension d'accélération dans la plage située entre 1 à 50 KeV et les charges électriques (28) sont éliminées du substrat par le courant électrique induit par le faisceau d'électrons (15).

2. Procédé selon la revendication 1, dans lequel
le faisceau d'électrons accéléré (42) est combiné avec le faisceau d'ions (41) et mis à rayonner sur une partie prédéterminée du substrat semi-conducteur (21) ensemble avec que le faisceau d'ions (41).

3. Procédé selon la revendication 1, dans lequel
le faisceau d'électrons accéléré est mis à rayonner sur une partie prédéterminée du substrat semi-conducteur en synchronisme avec le faisceau d'ions.

4. Procédé selon la revendication 1, dans lequel
le faisceau d'électrons accéléré est mis à rayonner sur une partie prédéterminée du substrat semi-conducteur à un moment différent que celui où est mis à rayonner le faisceau d'ions.

5. Procédé selon l'une quelconque des revendications précédentes, dans lequel la densité de courant du faisceau d'électrons est fixée pour être d'environ d'1/5 à 1/10 de la densité du courant du faisceau d'ions.
